# EUROPEAN PATENT APPLICATION

(11) **EP 3 893 263 A1**
(43) Date of publication of application: **13.10.2021**
(21) Application number: 20168281.2
(22) Date of filing: 06.04.2020
(51) Int. Cl.: H01J 37/04, H01J 37/09, H01J 37/12, H01J 37/26

(54) **APERTURE ASSEMBLY, BEAM MANIPULATOR UNIT, METHOD OF MANIPULATING CHARGED PARTICLE BEAMS, AND CHARGED PARTICLE PROJECTION APPARATUS**

(71) Applicant: ASML Netherlands B.V., 5500 AH Veldhoven (NL)
(72) Inventor: WIELAND, Marco Jan-Jaco, 5500 AH Veldhoven (NL)
(74) Representative: ASML Netherlands B.V.

(57) **Abstract**

The disclosure relates to apparatus and methods for manipulating charged particle beams. In one arrangement, an aperture assembly is provided that comprises a first aperture body (301) and a second aperture body (302). Apertures in the first aperture body are aligned with apertures in the second aperture body. The alignment allows charged particle beams to pass through the aperture assembly. The first aperture body comprises a first electrode system for applying an electrical potential to an aperture perimeter surface of each aperture in the first aperture body. The first electrode system comprises a plurality of electrodes. Each electrode is electrically isolated from each other electrode and electrically connected simultaneously to the aperture perimeter surfaces of a different one of a plurality of groups of the apertures in the first aperture body.

## Description

### FIELD

The embodiments provided herein relate generally to apparatus and methods for manipulating charged particle beams, particularly in the context of charged particle beam tools used for inspection of samples.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In an SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface it is possible to obtain an image representing characteristics of the material structure of the surface of the sample.

There is a general need to improve the throughput and other characteristics of inspection tools and methods that use charged particle beams.

### SUMMARY

According to an aspect of the invention, there is provided an aperture assembly for a beam manipulator unit of a charged particle projection apparatus, the aperture assembly comprising: a first aperture body and a second aperture body, wherein: a plurality of apertures in the first aperture body are aligned with a corresponding plurality of apertures in the second aperture body, the alignment being such as to allow a path of each of a respective plurality of charged particle beams to pass through the aperture assembly by passing through respective apertures in the first aperture body and the second aperture body; the first aperture body comprises a first electrode system for applying an electrical potential to an aperture perimeter surface of each aperture in the first aperture body; the second aperture body comprises a second electrode system for applying an electrical potential to an aperture perimeter surface of each aperture in the second aperture body; and the first electrode system comprises a plurality of electrodes, each electrode being electrically isolated from each other electrode and electrically connected simultaneously to the aperture perimeter surfaces of a different one of a plurality of groups of the apertures in the first aperture body.

According to an aspect of the invention, there is provided an aperture assembly for a beam manipulator unit of a charged particle projection apparatus, comprising: a first aperture body and a second aperture body, wherein: a plurality of apertures in the first aperture body are aligned with a corresponding plurality of apertures in the second aperture body, the alignment being such as to allow a path of each of a respective plurality of charged particle beams to pass through the aperture assembly by passing through respective apertures in the first aperture body and second aperture body; each of at least a subset of the apertures in the first aperture body consists of an elongate slit; and each corresponding aperture in the second aperture body consists of an opening that is smaller than the elongate slit in at least a direction parallel to a longest axis of the elongate slit.

According to an aspect of invention, there is provided a method of manipulating charged particle beams, comprising: directing a plurality of charged particle beams through an aperture assembly onto a sample; and electrostatically manipulating the charged particle beams by applying electrical potentials to electrodes in the aperture assembly, wherein: the aperture assembly comprises a first aperture body and a second aperture body; a plurality of apertures in the first aperture body are aligned with a corresponding plurality of apertures in the second aperture body so that each of the charged particle beams pass through the aperture assembly by passing through respective apertures in the first aperture body and the second aperture body; and the applying of electrical potentials comprises applying electrical potentials to a plurality of electrodes that are each electrically isolated from each other and electrically connected simultaneously to the aperture perimeter surfaces of a different one of a plurality of groups of the apertures of the first aperture body.

According to an aspect of invention, there is provided a method of manipulating charged particle beams, comprising: directing a plurality of charged particle beams through an aperture assembly onto a sample; and electrostatically manipulating the charged particle beams by applying electrical potentials to electrodes in the aperture assembly, wherein: the aperture assembly comprises a first aperture body and a second aperture body; a plurality of apertures in the first aperture body are aligned with a corresponding plurality of apertures in the second aperture body so that each of the charged particle beams pass through the aperture assembly by passing through respective apertures in the first aperture body and the second aperture body; the applying of electrical potentials comprises applying electrical potential differences between apertures in the first aperture body and corresponding apertures in the second aperture body; each of at least a subset of the apertures in the first aperture body consists of an elongate slit; and each corresponding aperture in the second aperture body consists of an opening that is smaller than the elongate slit in at least a direction parallel to a longest axis of the elongate slit.

According to an aspect of invention, there is provided an aperture assembly for a manipulator unit of a charged particle multi-beam projection system, the aperture assembly comprising: a first aperture body in which are defined a first array of apertures; and a second aperture body in which are defined a corresponding array of apertures that is aligned with the first array of apertures to define paths for respective charged particle beams of the multi-beam through the aperture assembly; a first electrode system associated with the first aperture body configured to apply an electrical potential to a perimeter surface of each aperture of the first aperture body; a second electrode system associated with the second aperture body configured to apply an electrical potential to a perimeter surface of each aperture of the second aperture body, wherein the first electrode system comprises a plurality of electrodes, each electrode being electrically isolated from each other electrode and electrically connected simultaneously to the perimeter surface of a different one of a plurality of groups of the apertures of the first aperture body.

According to an aspect of invention, there is provided an aperture assembly for a beam manipulator unit of a charged particle multi-beam projection apparatus, comprising: a first aperture body in which is defined a first plurality of apertures; and a second aperture body in which is defined a corresponding plurality of apertures that are positioned with respect to the first plurality of apertures to define paths for respective charged particle beams of the multi-beam through the aperture assembly wherein: each of at least a subset of the apertures in the first aperture body is an elongate slit; and each corresponding aperture of corresponding plurality of apertures to the elongate slit is an opening having an aspect ratio smaller than the elongate slit.

According to an aspect of invention, there is provided a beam manipulator unit of a charged particle multi-beam projection system, the manipulator unit comprising a lens comprising: an up-beam lens aperture array with an associated up-beam perturbing electrode array; and a down-beam lens aperture array with an associated down-beam perturbing electrode array, wherein: the up-beam lens aperture array, the down-beam lens aperture array and the perturbing arrays are positioned with respect to each other so that the apertures in each array define paths for respective charged particle beams of the multi-beam through the manipulator unit; and the up-beam and down-beam perturbing electrodes are controllable to apply perturbing fields to the fields generated by the lens during operation.

According to an aspect of invention, there is provided a method of manipulating charged particle beams, comprising: providing a lens comprising an up-beam lens aperture array with an associated up-beam perturbing electrode array; and a down-beam lens aperture array with an associated down-beam perturbing electrode array; passing multiple charged particle beams through respective apertures in each of the up-beam lens aperture array and the down-beam lens aperture array; and controlling the up-beam and down-beam perturbing electrodes to apply perturbing fields to fields generated by the lens.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary charged particle beam inspection apparatus.
Figure 2 is a schematic diagram illustrating an exemplary charged particle beam tool that is part of the exemplary charged particle beam inspection apparatus of Figure 1.
Figure 3 is a schematic diagram of a charged particle beam tool in which sub-beams travel in straight lines between condenser lenses and objective lenses.
Figure 4 is a schematic diagram of a charged particle beam tool in which collimators are provided between condenser lenses and objective lenses.
Figure 5 is a schematic diagram of a beam manipulator unit comprising an aperture assembly.
Figure 6 is a schematic diagram of a beam manipulator unit of the type depicted in Figure 4 in which the aperture assembly is integrated with a lens of a charged particle projection apparatus.
Figure 7 is a schematic top view of an example first electrode system or second electrode system comprising relatively wide elongate conductive strips aligned in a first direction.
Figure 8 is a schematic top view of an example second electrode system or first electrode system having relatively wide elongate conductive strips aligned in a second direction.
Figure 9 is a schematic top view of an example first electrode system or second electrode system having relatively narrow elongate conductive strips aligned in the first direction.
Figure 10 is a schematic top view of an example second electrode system or first electrode system having relatively narrow elongate conductive strips aligned in the second direction.
Figure 11 is a schematic top view of an example first electrode system or second electrode system having lower aspect ratio, tessellating conductive elements.
Figure 12 is a schematic top view of an example first electrode system or second electrode system having conductive elements comprising concentric loops.
Figure 13 is a schematic top view of a first electrode system or second electrode system comprising a single electrode electrically connected to all of the aperture perimeter surfaces of the respective aperture body.
Figure 14 is a schematic top view of a first electrode system or second electrode system in which each electrode is electrically isolated from each other electrode and electrically connected to the aperture perimeter surface of a different respective one of the apertures in the respective aperture body.
Figure 15 is a schematic top view of an aperture assembly in which an uppermost aperture body comprises elongate slits.
Figure 16 is a schematic side sectional view along line X-X of the unit of Figure 15.
Figure 17 is a schematic side sectional view along line Y-Y of the unit of Figure 15.
Figure 18 is a schematic side sectional view along line X-X of a unit of the type depicted in Figure 15 in a case where a lowermost aperture body comprises local integrated electronics for applying electrical potentials.
Figure 19 is a schematic side sectional view along line Y-Y of the unit of Figure 15 in the case where the lowermost aperture body comprises local integrated electronics for applying electrical potentials.
Figure 20 is a schematic top view of an example first electrode system or second electrode system having radially aligned elongate slits.
Figure 21 is a schematic top view of an example first electrode system or second electrode system having elongate slits aligned perpendicularly to the radial direction.
Figure 22 is schematic top view of an example first electrode system or second electrode system having parallel elongate slits aligned with the first direction.
Figure 23 is a schematic top view of an example second electrode system or first electrode system having parallel elongate slits aligned with the second direction.
Figure 24 is a schematic top view of an example third electrode system having elongate slits aligned at 45 degrees relative to elongate slits in an electrode system of a different aperture body.
Figure 25 is a schematic side sectional view of a portion of an aperture assembly having a third electrode system configured as depicted in Figure 24 and a fourth electrode system with circular openings, viewed along a direction perpendicular to the elongate slits of the third electrode system.
Figure 26 is a schematic side sectional view of the arrangement of Figure 25 viewed along a direction parallel to the elongate slits of the third electrode system.
Figure 27 is an example of an electron detection device integrated with a three-electrode objective lens.
Figure 28 is an example of an electron detection device integrated with a two-electrode objective lens.
Figure 29 is a bottom view of a detector module of the type depicted in Figure 27 or 28.
Figure 30 is a bottom view of an alternative detector module where beam apertures are in a hexagonal close packed array.
Figure 31 depicts a part of a detector module in cross section.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The following figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be considered as general references to charged particles, with the charged particles not necessarily being electrons.

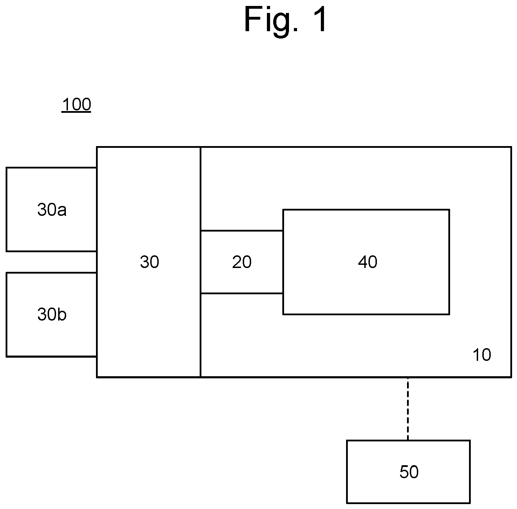

Reference is now made to Figure 1, which is a schematic diagram illustrating an exemplary charged particle beam inspection apparatus 100. The charged particle beam inspection apparatus 100 of Figure 1 includes a main chamber 10, a load lock chamber 20, a charged particle beam tool 40 (which may be referred to as an electron beam tool where electrons are used as the charged particles), an equipment front end module (EFEM) 30 and a controller 50. Charged particle beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure around the sample reaches a second pressure lower than the first pressure. After reaching the second pressure, the sample is transported to the charged particle beam tool 40 by which it may be inspected. A charged particle beam tool 40 may comprise a multi-beam electron-optical apparatus.

Controller 50 is electronically connected to charged particle beam tool 40. Controller 50 may be a processor (such as a computer) configured to control the charged particle beam inspection apparatus 100. Controller 50 may also include a processing circuitry configured to execute various signal and image processing functions. While controller 50 is shown in Figure 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus that operate under the second pressure.

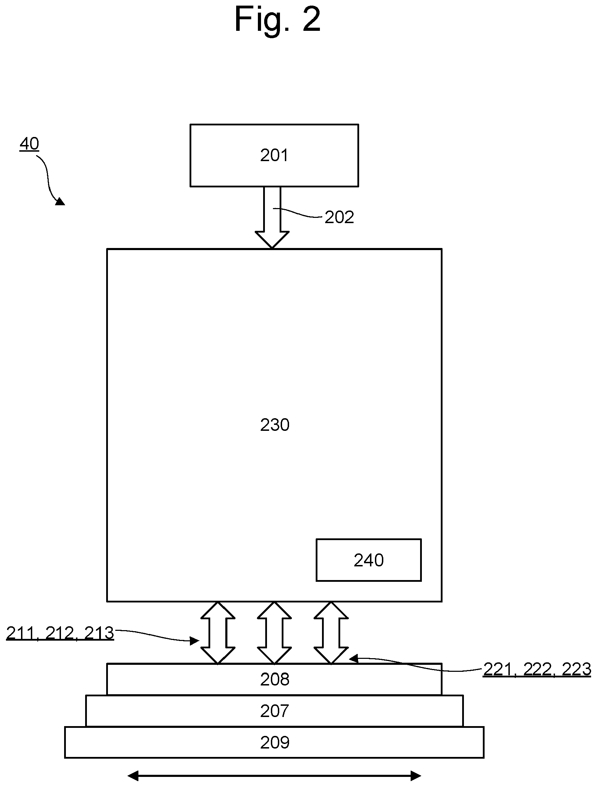

Reference is now made to Figure 2, which is a schematic diagram illustrating an exemplary charged particle beam tool 40 that is part of the exemplary charged particle beam inspection apparatus 100 of Figure 1. The charged particle beam tool 40 (also referred to herein as apparatus 40) may comprise a charged particle source 201 (e.g. an electron source), a projection apparatus 230, a motorized stage 209, and a sample holder 207. The charged particle source 201 and projection apparatus 230 may together be referred to as an electron-optical apparatus. The sample holder 207 is supported by motorized stage 209 so as to hold a sample 208 (e.g., a substrate or a mask) for inspection. The charged particle beam tool 40 may further comprise an electron detection device 240.

The charged particle source 201 may comprise a cathode (not shown) and an extractor or anode (not shown). The charged particle source 201 may be configured to emit electrons as primary electrons from the cathode. The primary electrons are extracted or accelerated by the extractor and/or the anode to form a charged particle beam 202 comprising primary electrons.

Projection apparatus 230 is configured to convert charged particle beam 202 into a plurality of sub-beams 211, 212, 213 and to direct each sub-beam onto the sample 208. Although three sub-beams are illustrated for simplicity, there may be many tens, many hundreds or many thousands of sub-beams. The sub-beams may be referred to as beamlets.

Controller 50 may be connected to various parts of charged particle beam inspection apparatus 100 of Figure 1, such as charged particle source 201, electron detection device 240, projection apparatus 230, and motorized stage 209. Controller 50 may perform various image and signal processing functions. Controller 50 may also generate various control signals to govern operations of the charged particle beam inspection apparatus 100, including the charged particle beam tool 40.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, electrons may be generated from the sample 208 which may include secondary electrons and backscattered electrons. The secondary electrons typically have electron energy ≤ 50 eV. The backscattered electrons typically have electron energy between 50 eV and the landing energy of primary sub-beams 211, 212, and 213.

Electron detection device 240 may be configured to detect secondary electrons and/or backscattered electrons and to generate corresponding signals which are sent to controller 50 or a signal processing system (not shown), e.g. to construct images of the corresponding scanned areas of sample 208. The electron detection device 240 may be incorporated into the projection apparatus 230 or may be separate therefrom, with a secondary optical column being provided to direct secondary electrons and/or backscattered electrons to the electron detection device 240.

The controller 50 may comprise an image processing system that includes an image acquirer (not shown) and a storage device (not shown). For example, the controller 50 may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the charged particle beam tool 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of detected charged particles (e.g. secondary electrons). The charged particle (e.g. electron) distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

A multi-beam electron beam tool may be provided that comprises a primary projection apparatus, a motorized stage and a sample holder. The primary projection apparatus may comprise an illumination apparatus. The primary projection apparatus may comprise one or more of the following components: an electron source, a gun aperture plate, a condenser lens, an aperture array, beam manipulators (that may comprise MEMS structures), an objective lens and a beam separator (e.g. a Wien filter). The sample holder is supported by the motorized stage. The sample holder is arranged to hold a sample (e.g., a substrate or a mask) for inspection.

The multi-beam electron beam tool may further comprise a secondary projection apparatus and an associated electron detection device. The electron detection device may comprise a plurality of electron detection elements.

The primary projection apparatus is arranged to illuminate a sample. In response to the incidence of primary sub-beams or probe spots on a sample, electrons are generated from the sample which include secondary electrons and backscattered electrons. The secondary electrons propagate in a plurality of secondary electron beams. The secondary electron beams typically comprise secondary electrons (having electron energy ≤ 50eV) and may also comprise at least some of the backscattered electrons (having electron energy between 50eV and the landing energy of primary sub-beams). A beam separator in the primary projection apparatus may be arranged to deflect the path of the secondary electron beams towards the secondary projection apparatus. The secondary projection apparatus subsequently focuses the path of secondary electron beams onto the plurality of elements of the electron detection device. The detection elements generate corresponding signals which may be sent to a controller or a signal processing system, e.g. to construct images of the corresponding scanned areas of sample.

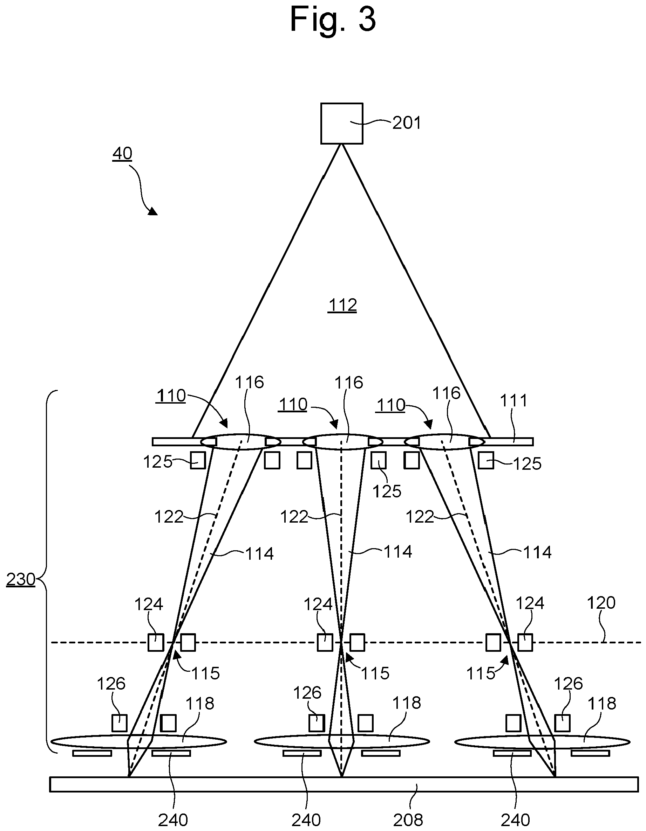

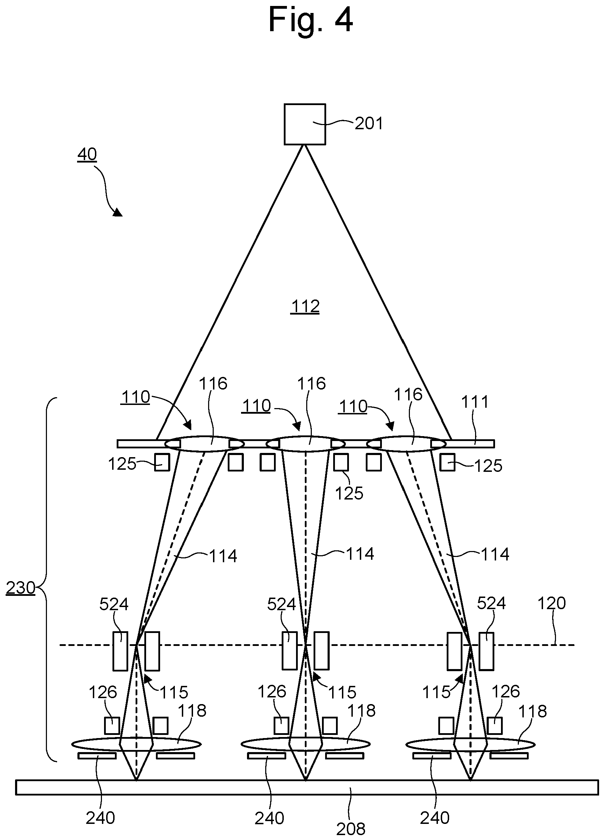

Figures 3 and 4 are schematic diagrams each exemplifying a charged particle beam tool 40 of an embodiment. The charged particle beam tool 40 comprises a projection apparatus 230. The charged particle beam tool 40 may be used as part of a charged particle beam inspection apparatus 100 as described above. The projection apparatus 230 may be incorporated into other types of charged particle beam tool 40, such as the multi-beam electron beam tool referred to above.

The projection apparatus 230 comprises a condenser lens array. The condenser lens array divides a beam 112 of charged particles into a plurality of sub-beams 114. In an embodiment, the condenser lens array focuses each of the sub-beams 114 to a respective intermediate focus 115.

In the embodiment shown, the condenser lens array comprises a plurality of beam apertures 110. The beam apertures 110 may be formed, for example, by openings in a substantially planar beam aperture body 111. The beam apertures 110 divide a beam 112 of charged particles into a corresponding plurality of sub-beams 114. In some embodiments, the charged particles comprise or consist of electrons. The charged particles are provided by a charged particle source 201. The charged particle source 201 may or may not form part of the charged particle beam tool 40. The charged particle source 201 may be configured in any of the ways described above with reference to Figure 2. The charged particle source 201 may thus comprise a cathode (not shown) and an extractor or anode (not shown). The charged particle source 201 may comprise a high brightness thermal field emitter with a desirable balance between brightness and total emission current.

In the embodiment shown, the condenser lens array comprises a plurality of condenser lenses 116. The plurality of condenser lenses 116 may be considered an array of condenser lenses and may be in a common plane. Each condenser lens 116 may be associated with a corresponding one of the beam apertures 110. Each condenser lens 116 may, for example, be formed within a beam aperture 110, be positioned directly adjacent to a beam aperture 110, and/or be integrated with the beam aperture body 111 (e.g. with the beam aperture body 111 forming one of the electrodes of the condenser lens 116). Thus, a plate or array that forms an electrode of the condenser lens array may also serve as a beam aperture. The object forming the plate or array may be referred to as an aperture body.

The condenser lenses 116 may comprise multi-electrode lenses. The lens array may take the form of at least two plates, acting as electrodes, with an aperture in each plate aligned with each other and corresponding to the location of a sub-beam. At least two of the plates are maintained during operation at different potentials to achieve the desired lensing effect. In an arrangement the condenser lens array is formed of three plate arrays in which charged particles have the same energy as they enter and leave each lens, which arrangement may be referred to as an Einzel lens. Einzel lenses (e.g. including those that may be used in the condenser lens array) may also typically have electrodes (e.g. plate arrays) arranged symmetrically relative to each other, such as with entry and exit electrodes equidistant from an electrode between them. The entry and exit electrodes are also typically held at the same potential. In other arrangements the condenser lens is formed of four or more electrodes (e.g. plate arrays) in which charged particles have the same energy as they enter and leave each lens. Such arrangements may again have entry and exit electrodes held at the same potential and/or symmetric arrangements of the electrodes, but because there are more than three electrodes these arrangements may not strictly be considered Einzel lenses. Arranging the lenses (whether or not the lenses are strictly Einzel lenses) so that the charged particles have the same energy as they enter and leave each lens means that dispersion only occurs within each lens (between entry and exit electrodes of the lens), thereby limiting off-axis chromatic aberrations. When the thickness of the condenser lenses is low, e.g. a few mm, such aberrations have a small or negligible effect.

Each condenser lens 116 focuses one (e.g. a different respective one) of the sub-beams 114 to a respective intermediate focus 115. The intermediate foci 115 of the plurality of condenser lenses 116 may substantially lie in a common plane, which may be referred to as an intermediate image plane 120.

The projection apparatus 230 further comprises a plurality of objective lenses 118. The objective lenses 118 are downstream from the intermediate foci (and intermediate image plane 120). The plurality of objective lenses 118 may be considered an array of objective lenses and may be in a common plane. Each objective lens 118 projects one of the sub-beams 114 (from a corresponding condenser lens 116) onto a sample 208 to be assessed. Thus, there may be a one-to-one correspondence between the condenser lenses 116 and the objective lenses 118, with each sub-beam 114 propagating between a pair of condenser lens 116 and objective lens 118 that is unique to that sub-beam. A corresponding one-to-one correspondence may exist between the beam apertures 110 of the condenser lens array and the objective lenses 118.

As exemplified in Figure 3, the projection system 230 may be configured so that a path 122 of each sub-beam 114 (e.g. of a principle ray of the sub-beam 114, corresponding to a beam axis of the sub-beam 114) is substantially a straight line from each condenser lens 116 to a corresponding objective lens 118 (i.e. to the objective lens 118 that corresponds to that condenser lens 116). The straight path may further extend to the sample 208. Alternatively, as exemplified in Figure 4, collimators 524 may be provided between the condenser lenses 116 and the objective lenses 118, for example in the intermediate image plane 120. The collimators 524 collimate the sub-beams. The collimation of the sub-beams reduces field curvature effects at the objective lenses 118, thereby reducing errors caused by field curvature, such as astigmatism and focus error.

In some embodiments, as exemplified in Figures 3 and 4, the projection apparatus 230 further comprises one or more aberration correctors 124, 125, 126 that reduce one or more aberrations in the sub-beams 114. In an embodiment, each of at least a subset of the aberration correctors 124 is positioned in, or directly adjacent to, a respective one of the intermediate foci 115 (e.g. in or adjacent to the intermediate image plane 120). The sub-beams 114 have a smallest cross-sectional area in or near a focal plane such as the intermediate plane 120. This provides more space for aberration correctors 124 than is available elsewhere, i.e. upbeam or downbeam of the intermediate plane 120 (or than would be available in alternative arrangements that do not have an intermediate image plane 120). In an embodiment, aberration correctors 124 positioned in, or directly adjacent to, the intermediate foci 115 (or intermediate image plane 120) comprise deflectors to correct for the source 201 appearing to be at different positions for different beams. Correctors 124 can be used to correct macroscopic aberrations resulting from the source 201 that prevent a good alignment between each sub-beam 114 and a corresponding objective lens 118. The aberration correctors 124 may correct aberrations that prevent a proper column alignment. Such aberrations may also lead to a misalignment between the sub-beams 114 and the correctors 124. For this reason, it may be desirable to additionally or alternatively position aberration correctors 125 at or near the condenser lenses 116 (e.g. with each such aberration corrector 125 being integrated with, or directly adjacent to, one or more of the condenser lenses 116). This is desirable because at or near the condenser lenses 116 aberrations will not yet have led to a shift of corresponding sub-beams 114 because the condenser lenses 116 are vertically close or coincident with the beam apertures 110. A challenge with positioning correctors 125 at or near the condenser lenses 116, however, is that the sub-beams 114 each have relatively large cross-sectional areas and relatively small pitch at this location, relative to locations further downstream.

In some embodiments, as exemplified in Figures 3 and 4, each of at least a subset of the aberration correctors 126 is integrated with, or directly adjacent to, one or more of the objective lenses 118. In an embodiment, these aberration correctors 126 reduce one or more of the following: field curvature; focus error; and astigmatism. Additionally or alternatively, one or more scanning deflectors (not shown) may be integrated with, or directly adjacent to, one or more of the objective lenses 118 for scanning the sub-beams 114 over the sample 208. Such an arrangement may be implemented for example as described in EP2425444A1 hereby incorporated by reference in particular to the disclosure of the use of an aperture array as a scanning deflector.

The aberration correctors 124, 125 may be CMOS based individual programmable deflectors as disclosed in EP2702595A1 or an array of multipole deflectors as disclosed EP2715768A2, of which the descriptions of the beamlet manipulators in both documents are hereby incorporated by reference.

In an embodiment, aberration correctors, for example the aberration correctors 126 associated with the objective lenses 118, comprise field curvature correctors that reduce field curvature. Reducing field curvature reduces errors caused by field curvature, such as astigmatism and focus error. In the absence of correction, significant field curvature aberration effects are expected to occur at the objective lenses 118 in embodiments where the sub-beams 114 propagate along straight-line paths between the condenser lenses 116 and the objective lenses 118, as exemplified in Figure 3, due to the resulting oblique angles of incidence onto the objective lenses 118.

In an embodiment, the field curvature correctors are integrated with, or directly adjacent to, one or more of the objective lenses 118. In an embodiment, the field curvature correctors comprise passive correctors. Passive correctors could be implemented, for example, by varying the diameter and/or ellipticity of apertures of the objective lenses 118. The passive correctors may be implemented for example as described in EP2575143A1 hereby incorporated by reference in particular to the disclosed use of aperture patterns to correct astigmatism. The passive nature of passive correctors is desirable because it means that no controlling voltages are required. In embodiments where the passive correctors are implemented by varying the diameter and/or ellipticity of apertures of the objective lenses 118, the passive correctors provide the further desirable feature of not requiring any additional elements, such as additional lens elements. A challenge with passive correctors is that they are fixed, so the required correction needs to be carefully calculated in advance. Additionally or alternatively, in an embodiment, the field curvature correctors comprise active correctors. The active correctors may controllably correct charged particles to provide the correction. The correction applied by each active corrector may be controlled by controlling the potential of each of one or more electrodes of the active corrector. In an embodiment, passive correctors apply a coarse correction and active correctors apply a finer and/or tunable correction.

Examples of a beam manipulator unit 300 are described below. The beam manipulator unit 300 comprises an aperture assembly 370. The beam manipulator unit 300 may be provided as part of any of the configurations of projection apparatus 230 described above. The beam manipulator unit 300 applies an effect to a charged particle beam passing through the beam manipulator unit 300. The effect may comprise correction of an aberration or multipole or focus error associated with the charged particle beam. The beam manipulator unit 300 may be used to implement one or more of the aberration correctors 124, 125, 126 mentioned above. A beam manipulator unit 300 may therefore be positioned in, or directly adjacent to, a respective one of the intermediate foci 115. Alternatively or additionally, a beam manipulator unit 300 may be integrated with, or directly adjacent to, one or more of the objective lenses 118. Alternatively or additionally, a beam manipulator unit 300 may be integrated with, or directly adjacent to, one or more of the condenser lenses 116.

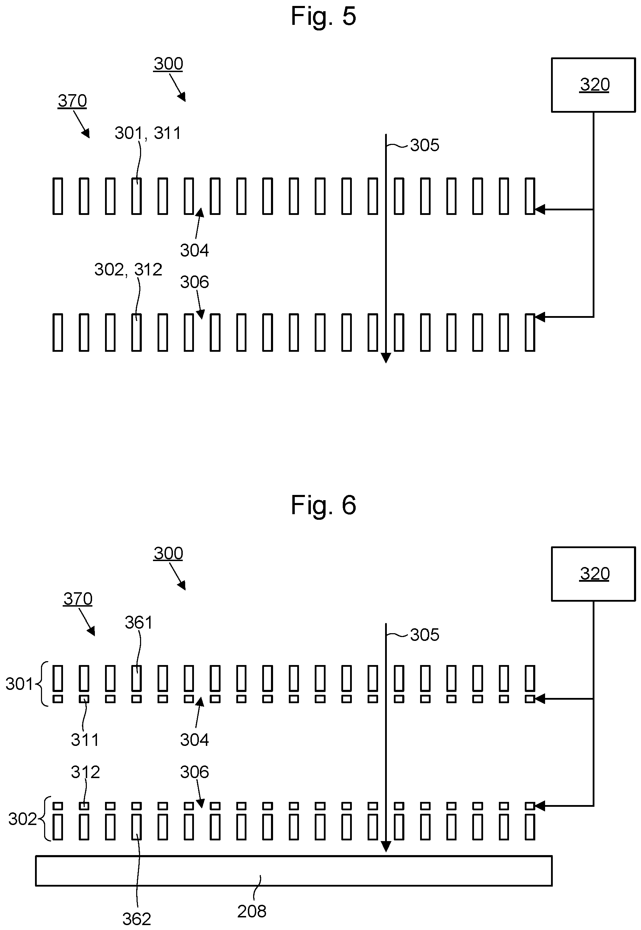

As exemplified in Figures 5 and 6, the aperture assembly 370 may comprise a first aperture body 301 and a second aperture body 302. A plurality of apertures 304 in the first aperture body 301 are aligned with a corresponding plurality of apertures 306 in the second aperture body 302. The alignment is such as to provide a charged particle path for each of a respective plurality of charged particle beams. Following the charged particle path, each charged particle beam may pass through the aperture assembly 370 through respective apertures in the first aperture body 301 and the second aperture body 302. Where a charged particle beam is incident obliquely onto the aperture assembly 370, an aperture 306 in the second aperture body 302 may be displaced laterally relative to a corresponding aperture 304 in the first aperture body 301 (i.e. so as not to be aligned in the vertical direction). The lateral displacement in this case achieves the necessary alignment with the path of the charged particle beam to allow the charged particle beam to pass through the aperture assembly 370. Where a charged particle beam is incident orthogonally onto the aperture assembly 370, an aperture 306 in the second aperture body 302 may be positioned directly beneath a corresponding aperture 304 in the first aperture body 301 (i.e. so as to be aligned in the vertical direction). An example path of a charged particle beam is labelled 305 in Figures 5 and 6. The apertures 304 in the first aperture body 301 may have the same size and/or shape as the apertures 306 in the second aperture body 302. Alternatively, the apertures 304 in the first aperture body 301 may have a different size and/or shape than the apertures 306 in the second aperture body 302. In some arrangements all of the apertures 304, 306 are circular or oval, but other shapes are possible. The first aperture body 301 and the second aperture body 302 may be substantially planar. Typically, a maximum in-plane dimension of each aperture 304 (e.g. diameter) in the first aperture body 301 is less than a separation between the first aperture body 301 and the second aperture body 302. In some embodiments, however, the maximum in-plane dimension of each aperture 304 (e.g. diameter) in the first aperture body 301 may be equal to or larger than a separation between the first aperture body 301 and the second aperture body 302 (e.g. where the first aperture body 301 and the second aperture body 302 form part of an Einzel lens).

An electrical driving unit 320 is provided for applying electrical potentials to at least the aperture perimeter surfaces that define the apertures 304, 306 in the first aperture body 301 and second aperture body 302. Thus, during operation, a plurality of charged particle beams are directed through the aperture assembly towards a sample 208. The electrical driving unit 320 may be provided, for example, as part of a charged particle projection system 230 and/or beam tool 40 comprising the manipulator unit 300 or as part of the manipulator unit 300. The charged particle beam tool 40 may be used as part of a charged particle beam inspection apparatus 100 as described above. The electrical driving unit 320 may be provided in a portion of the charged particle beam tool 40 referred to as an electron-optical system or apparatus, as described above.

Embodiments are generally exemplified herein with the first aperture body 301 upbeam from the second aperture body 302. The first aperture body 301 and the second aperture 302 may, however, be provided in the reverse configuration, with the second aperture body 302 upbeam from the first aperture body 301.

The aperture assembly 370 is used to manipulate the charged particle beam by controlling an electric field in a region through which the charged particle beam passes. This is achieved by applying suitable electrical potentials to electrodes of the aperture assembly 370.

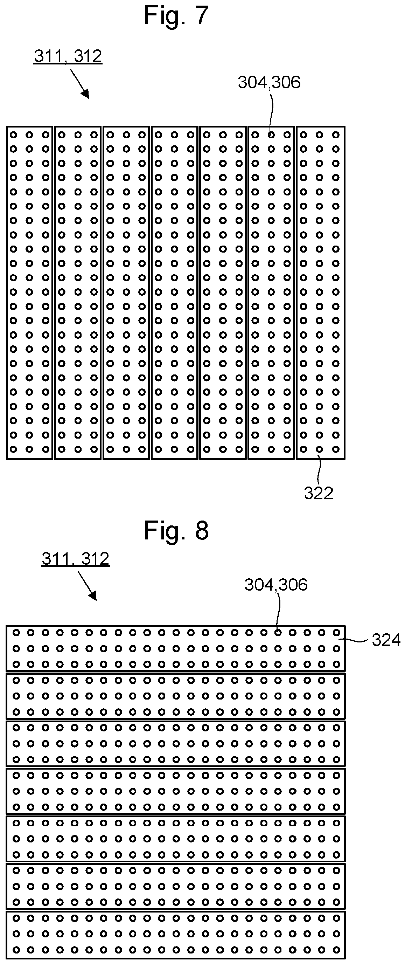

In some embodiments, the first aperture body 301 comprises a first electrode system 311. The first electrode system 311 may be formed in various ways. The first electrode system 311 may be provided as an integral part of the first aperture body 301, as depicted schematically in Figure 5. Alternatively, as depicted schematically in Figure 6, the first electrode system 311 may be provided as a conductive layer or structure on a first support structure 361, as depicted in Figure 6. In an approach, the first electrode system 311 may be formed using a silicon-on-insulator process. The first electrode system 311 may be provided as a conductive layer or structure on an insulating layer of silicon oxide. The first electrode 311 system may comprise a metalized layer and/or a conductive semiconductor such as silicon or doped silicon. The first electrode system 311 may comprise a metal, such as molybdenum or aluminum. Examples of first electrode systems 311 are depicted in Figures 7-12 and discussed below. The first electrode system 311 is configured to apply an electrical potential to an aperture perimeter surface of each aperture 304 of the first aperture body 301. The first electrode system 311 may comprise a plurality of electrodes. Each electrode may comprise a conductive element and/or conductive track. Each electrode is electrically isolated from each other electrode and electrically connected simultaneously to the aperture perimeter surfaces of a different one of a plurality of groups of the apertures 304 of the first aperture body 301. Each group contains plural apertures 304. Each electrode is therefore capable of applying an electrical potential simultaneously to plural apertures 304 independently of the potential applied to other apertures 304 in the first aperture body 301. Fewer electrodes are therefore needed than would be the case if each electrode were connected to one aperture only. Having fewer electrodes facilitates routing of the electrodes, thereby facilitating manufacture and optionally enabling a denser pattern of apertures in the electrode. Controlling the potentials applied to groups of apertures 304 independently provides a greater level of control than if all of the apertures were connected together electrically, such as when the apertures are formed in an integral metallic plate. An improved balance of ease of manufacture of the beam manipulator unit and controllability of the beam manipulation is therefore provided.

In some embodiments, the second aperture body 302 comprises a second electrode system 312. The second electrode system 312 applies an electrical potential to an aperture perimeter surface of each aperture 306 of the second aperture body 302. The second electrode system 312 may be configured in any of the ways described above for the first electrode system 311. The second electrode system 312 may thus comprise a plurality of electrodes formed on a second support structure 362. Each electrode may be electrically isolated from each other electrode and electrically connected simultaneously to the aperture perimeter surfaces of a different one of a plurality of groups of the apertures 306 of the second aperture body 302. Alternatively, the second electrode system 312 may comprise an electrode electrically connected to all of the aperture perimeter surfaces of the second aperture body 302. The second electrode system 312 may therefore be implemented as a single integral conducting plate, such that the second aperture body 302 and second electrode system 312 are provided by the same element (i.e. such that the second aperture body consists of the second electrode system 312).

In some embodiments, as exemplified in Figures 7-12, the same number of apertures 304 are provided in each of at least two of the groups of apertures 304 in the first aperture body 301. Alternatively or additionally, the same number of apertures 306 may be provided in each of at least two of the groups of apertures 306 in the second aperture body 302.

In some embodiments, as exemplified in Figures 7-10, each electrode of the first electrode system 311 comprises an elongate conductive strip 322, 324 and/or each electrode of the second electrode system 312 comprises an elongate conductive strip 322, 324. The respective elongate conductive strips in each electrode system may be implemented as opposing parallel plates. The conductive strips 322, 324 of each respective electrode system are preferably parallel to each other and/or substantially linear. Arranging the electrodes in conductive strips 322, 324 in the respective electrode system makes routing easier because electrical connections to the conductive strips 322, 324 can be made at the ends of the conductive strips 322, 324. In some arrangements, the conductive strips 322, 324 are arranged to extend to peripheral edges of the first electrode system 311 or second electrode system 312, as shown schematically in Figures 7-10. Extending the conductive strips 322, 324 to the peripheral edges means that electrical connections to the conductive strips 322, 324 can be made at the peripheral edges. The peripheral edges of the electrode systems shown in the figures are schematic. The shape and relative size of the peripheral surfaces may be different in practical arrangements. The peripheral surfaces may be dimensioned, for example, to contain many more of the apertures 304 and 306 than shown in the figures.

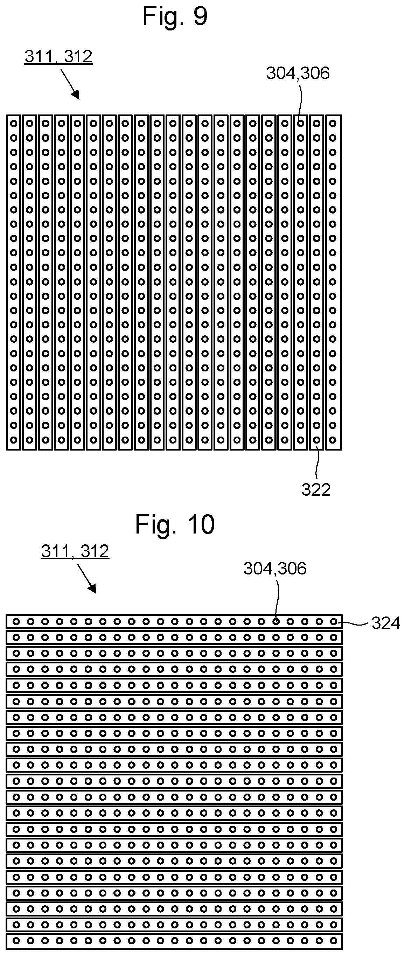

In some embodiments, the apertures 304 in the first aperture body 301 and/or the apertures 306 in the second aperture body 302 are each arranged in a regular array. The regular array has a repeating unit cell. The regular array may comprise a square array, rectangular array, or hexagonal array, for example. The apertures 304 or 306 may alternatively be arranged in an irregular arrangement comprising a plurality of the apertures 304 or 306, which may be referred to as an irregular array. In arrangements having a regular array, the conductive strips 322, 324 may be made parallel to each other and perpendicular to a principle axis of the array. In the examples shown in Figures 7-10, the apertures 304, 306 are arranged in a square array. The regular array may have one principle axis being horizontal in the plane of the page and another principle axis being vertical in the plane of the page. The conductive strips 322 in Figures 7 and 9 are thus parallel to each other and perpendicular to the horizontal principle axis. The conductive strips 324 in Figures 8 and 10 are parallel to each other and perpendicular to the vertical principle axis.

The conductive strips 322, 324 may each have a short axis and a long axis. In the example of Figures 7 and 9, each short axis is horizontal and each long axis is vertical. In the example of Figures 8 and 10, each short axis is vertical and each long axis is horizontal. A pitch of the conductive strips 322, 324 parallel to the short axis may be larger than a pitch of the array parallel to the short axis. Each vertical conductive strip may therefore comprise multiple columns of apertures 304, 306 and/or each horizontal strip may therefore comprise multiple rows of apertures 304, 306. This approach provides a good balance between controllability and ease of manufacture. Alternatively, a pitch of the conductive strips 322, 324 parallel to the short axis may be equal to the pitch of the array parallel to the short axis, which provides finer spatial control of the electrical field.

In an embodiment, conductive strips 322 of the first electrode system 311 are non-parallel with, e.g. perpendicular to, conductive strips 324 of the second electrode system 322. This arrangement may be particularly preferable, for example, where the conductive strips 322 of the first electrode system 311 are parallel to each other and the conductive strips 324 of the second electrode system 312 are parallel to each other. For example, the first electrode system 311 may comprise conductive strips 322 as shown in Figure 7 or 9 and the second electrode system 312 may comprise conductive strips 324 as shown in Figure 8 or 10 or vice versa. Crossing the conductive strips 322, 324 in different electrode systems 311, 312 in this way provides a wide range of possible combinations of potential difference between corresponding apertures 304, 306 in the first aperture body 301 and second aperture body 302 without making routing of electrical connections to the respective conductive strips 322, 324 more difficult.

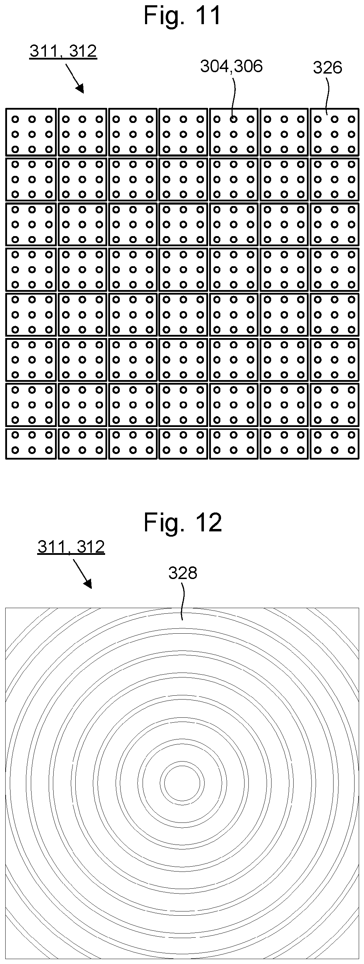

In a further arrangement, as exemplified in Figure 11, the plurality of electrodes comprises a plurality of conductive elements 326 that tessellate with each other. In the example shown, the conductive elements 326 are square. Other tessellating shapes may be used. This approach may provide more degrees of freedom for manipulating charged particles in comparison to arrangements using conductive strips as discussed above with reference to Figures 7-10, but routing of electrical signals to the individual electrodes may be more complex.

In a further arrangement, as exemplified in Figure 12, the plurality of electrodes comprises a plurality of conductive elements 328 comprising at least portions of concentric loops, e.g. at least portions of concentric rings such as circular rings. This approach may allow efficient correction of aberrations having the same or similar symmetry to the concentric loops. Routing of electrical signals to the individual electrodes may be more complex, however, than for arrangements using conductive strips as discussed above with reference to Figures 7-10.

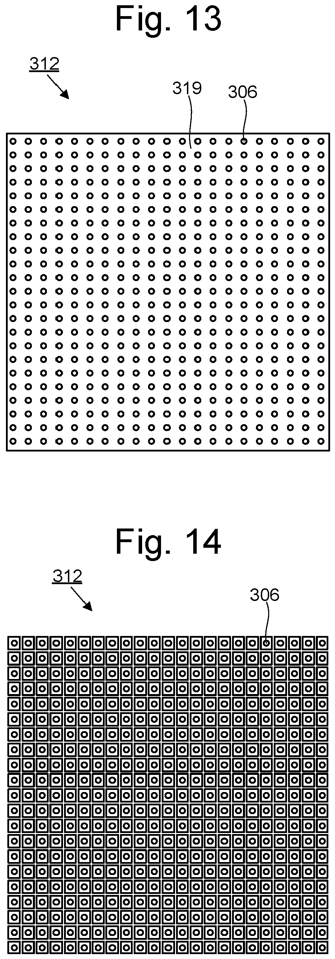

In some embodiments, the first electrode system 311 comprises a plurality of electrodes that are each connected to a group of aperture perimeter surfaces as described above with reference to Figures 7-12, and the second electrode system 312 comprises a single electrode 319 as exemplified in Figure 13. The single electrode 319 is electrically connected to all of the aperture perimeter surfaces of the second aperture body 302. The aperture perimeter surfaces of the second aperture body 302 are therefore held at the same electrical potential. Alternatively, the first electrode system 311 comprises a plurality of electrodes that are each connected to a group of aperture perimeter surfaces as described above with reference to Figures 7-12, and the second electrode system 312 comprises a plurality of electrodes that are each electrically isolated from each other and electrically connected to the aperture perimeter surface of a different respective one of the apertures of the second aperture body 302, as exemplified in Figure 14.

In some embodiments, the aperture assembly 370 is used with a charged particle projection apparatus 230. The charged particle projection apparatus 230 may form part of a charged particle beam tool 40. The charged particle beam tool 40 may comprise any type of tool that uses charged particle beams. The charged particle beam tool 40 and/or projection apparatus 230 comprises a plurality of lenses. Each lens projects a respective sub-beam of charged particles. In a charged particle beam tool 40 of the type depicted in Figure 3 or 4, the plurality of lenses may comprise the plurality of condenser lenses 116 or the plurality of objective lenses 118 of the projection apparatus 230. In other charged particle beam tools 40, other pluralities of lenses may be provided.

In such embodiments, the aperture assembly 370 may be integrated with, or directly adjacent to, the plurality of lenses. In an embodiment, each of the lenses comprises a multi-electrode lens. In this case, the first aperture body 301 may comprise a first electrode of the multi-electrode lens. In the schematic structure shown in Figure 6, the first electrode of the multi-electrode lens may be the first support structure 361 of the first aperture body 301. The plurality of electrodes of the first electrode system 311 are electrically isolated from the first electrode of the multi-electrode lens. This may be achieved by providing an electrically insulating layer between the first electrode system 311 and the first support structure 361 (acting as electrode of the multi-electrode lens) in Figure 6. In an embodiment, the second aperture body 302 comprises a second electrode of the multi-electrode lens. In the schematic structure shown in Figure 6, the second electrode of the multi-electrode lens may be the second support structure 362 of the second aperture body 302. The plurality of electrodes of the second electrode system 312 are electrically isolated from the second electrode of the multi-electrode lens.

The plurality of lenses that the aperture assembly 370 is integrated with, or directly adjacent to, may comprise a plurality of objective lenses 118. The objective lenses 118 may be configured in any of the ways described above with reference to Figures 3 and 4. Alternatively or additionally, the plurality of lenses that the aperture assembly 370 is integrated with, or directly adjacent to, may comprise a plurality of condenser lenses 116. Alternatively or additionally, the aperture assembly 370 is provided in, or directly adjacent to, the intermediate image plane 120 containing the intermediate foci 115 of sub-beams focused by the condenser lenses 116. The condenser lenses 116 may be configured in any of the ways described above with reference to Figures 3 and 4.

The first electrode system 311 and second electrode system 312 may be configured to provide perturbations (which may be referred to as perturbing fields) to a global focusing field provided by the first and second electrodes of each of the multi-element lenses (and any other electrodes of the multi-element lens). The first electrode system 311 and second electrode system 312 may, for example, apply local corrections to focus. In relation to embodiments of this type, the first electrode system 311 and second electrode 312 may thus be referred to as perturbing electrode systems, perturbing electrode arrays, or local focus correcting electrodes. The local corrections to focus may differ between different sub-beams passing through the manipulator unit. The local corrections to focus may involve differences in potential between different electrodes of the first electrode system 311, or between different electrodes of the second electrode system 312, that are small in comparison with an average overall potential difference between the first electrode and the second electrode of the multi-element lens. The electrical driving unit 320 may be configured to control potentials of the electrodes of the first electrode system 311 and/or second electrode system 312 to achieve this. The control may be such that a potential difference between the highest potential electrode and the lowest potential electrode of the first electrode system 311 is smaller than (optionally less than 50% of, optionally less than 10% of, optionally less than 5% of, optionally less than 1% of, optionally less than 0.1% of) a difference between an average potential of the electrodes of the first electrode system 311 and an average potential of the electrodes of the second electrode system 312. In one particular implementation, for example, the first electrode of the multi-electrode lens (which has a potential equal to or close to the average of the potentials of the electrodes of the first electrode system 311) is provided at 30kV, the second electrode of the multi-electrode lens (which has a potential equal to or close to the average of the potentials of the electrodes of the second electrode system 312) is provided at 2.5kV and deviations from these potentials of the order of 100V are provided by the electrodes of the first electrode system 311 and/or the second electrode system 312. Based on the focal length being given by the known formula *f* = 4 ∗ *U_{beam}*/*E_{local},* where *U_{beam}* is the local energy of the charged particle beam and *E_{local}* is the local electric field strength, it is expected that such deviations in potential could apply focal length changes of around 1 micron for a typical configuration involving electrons as the charged particles. The approach can therefore be used to provide macroscopic focus and/or levelling corrections. The corrections may, for example, be used to correct for focal plane deviations due to any one or more of the following:
- finite fabrication tolerances: e.g. flatness (or bow) and/or control of spacing between electrodes of the objective lenses 118,
- mechanical mounting tolerances and deformations induced by mechanical mounting of the objective lenses 118,
- deformations induced by the force of electrostatic fields,
- for embodiments without the collimators 525: field curvature due to non-telecentric passage through the objective lenses 118, and
- field curvature of the condenser lenses 116 (because beams are not collimated when passing through the condenser lenses 116).

The integration of the beam manipulator unit 300 may be implemented particularly efficiently with first and second electrode systems 311, 312 comprising crossed conductive strips 322, 324 as described above. In the case of a two electrode multi-electrode lens, conductive strips 324 aligned along an *X* direction may be formed on the first electrode and conductive strips 322 aligned along a *Y* direction may be formed on the second electrode. The focal plane can then be corrected according to the following function: Δ*f* = *f*(*X*) + *f*(*Y*)*,* where *f*(*X*) and *f*(*Y*) represent focal corrections that can be applied as a function of *X* and *Y* respectively. The focal corrections may typically be applied by providing a potential that changes relatively incrementally from one conductive strip to the next, such that any potential differences between neighboring conductive strips are kept relatively low while still providing a relatively large change in potential over longer length scales. The possible corrections that can be applied with the example geometry described above include any tilted plane correction, as well as higher order corrections such as curved surfaces where the curve is aligned along the *X* or *Y* axis or corrections that are rotation symmetric with an *R*² dependence (where *R*² = *X*² + *Y*²)*.* The approach can also be used with multi-electrode lenses configured to operate as Einzel lenses.

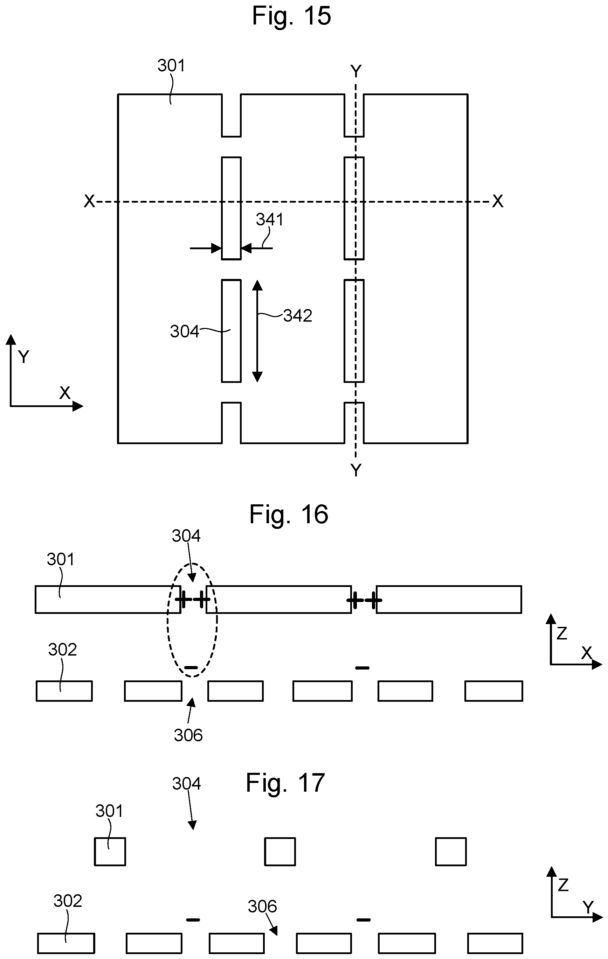

In one class of embodiment, as exemplified in Figures 15-17, each of at least a subset of the apertures 304 in the first aperture body 301 consists of an elongate slit. Each elongate slit may be substantially linear. The elongate slit may have an aspect ratio lower than 0.5. As depicted in Figure 15, the ratio of the width 341 of the elongate slit to the length 342 of the elongate slit is thus less than 0.5. In addition, each corresponding aperture 306 in the second aperture body 302 consists of an opening that is smaller than the elongate slit in at least a direction parallel to a longest axis of the elongate slit. Each of at least a subset of the openings may have substantially one of the following shapes: circle, oval, ellipse. The longest axis of the elongate slit will be the length of the elongate slit when the elongate slit is rectangular or a major axis of the elongate slit when the elongate slit is oval or elliptical. The opening may, for example, have an aspect ratio between 0.5 and 1.0, optionally between 0.9 and 1.0, optionally substantially equal to 1.0. Thus, elongate slits in the first aperture body 301 may be aligned with openings in the second aperture body 302 that are less elongate (i.e. have a smaller aspect ratio, in the sense that the aspect ratio is nearer to 1.0) or not elongate (e.g. circular, oval or elliptical openings with an aspect ratio near to 1.0). Alternatively, the openings in the second aperture body 302 may be elongate but non-parallel to the elongate slits in the first aperture 301. This approach may be less desirable than having openings with aspect ratios nearer to 1 because it may unnecessarily complicate routing in the second aperture body 302 by making less space available for the routing.

The effect of having an aperture 304 in the first aperture body 301 shaped as an elongate slit is to make a contribution to a lensing effect by the aperture 304 asymmetric. The contribution is negligible in a direction parallel to the elongate slit and strengthened (relative to a circular opening) in a direction perpendicular to the slit. The effect of the corresponding opening in the second aperture body 302 is to contribute, with an opposite polarity, a stronger lensing effect (relative to the elongate slit) in the direction parallel to the elongate slit and a weaker or negligible lensing effect (relative to the elongate slit) in the direction perpendicular to the elongate slit. As mentioned above, the opening in the second aperture body 302 is typically circular or near circular. However, the effect is made stronger when the opening in the second aperture body 302 is elongate and non-parallel (e.g. perpendicular) to the elongate slit in the first aperture body 301. In the perpendicular case, for example, the contribution to the lensing effect by the opening in the second aperture body 302 is twice as strong in the direction parallel to the elongate slit in the first aperture body 301 relative to the case where the opening in the second aperture body 302 is circular, and is negligible in the direction perpendicular to the elongate slit in the first aperture body 301.

In an embodiment, the length 342 of each elongate slit in the first aperture body 301 is large enough relative to a separation between the first aperture body 301 and the second aperture body 302 that the ends of the elongate slit are shielded by the second aperture body 302 (i.e. effectively making the ends non-existent for charged particles passing through the aperture assembly 370). The length of the elongate slit may, for example, typically be at least two times, optionally at least three times, larger than the separation between the first aperture body 301 and the second aperture body 302.

The separation between the first aperture body 301 and the second aperture body 302 is desirably larger (optionally at least two times larger, optionally at least three times larger) than the width of each elongate slit. This provides a sufficient distance from the elongate slit for the field to become near uniform before reaching the second aperture body 302, despite the perturbation to the field by the elongate slit in the width direction of the elongate slit.

The separation between the first aperture body 301 and the second aperture body 302 is also desirably larger (optionally at least two times larger, optionally at least three times larger) than a maximum in-plane dimension of each aperture 306 in the second aperture body 302 (e.g., the diameter of a circular opening). This again provides sufficient distance from the aperture 306 for the field to become near uniform before reaching the first aperture body 301.

A largest in-plane dimension of each aperture 306 in the second aperture body 302 may be substantially equal to a smallest in-plane dimension (i.e. the width) of the corresponding elongate slit in the first aperture body 301. This allows the apertures 306 to perform their role efficiently while minimizing disruption of routing in the second aperture body 302. Because of the increased space available for routing in the second aperture body 302, it is desirable to provide more of the routing in the second aperture body 302 than the first aperture body 301 (as discussed further below).

As mentioned above, the elongation of the elongate slit results in a lensing effect from the elongate slit being smaller parallel to the length of the elongate slit and larger in the perpendicular direction. This allows a four-pole effect to be created. The four-pole effect allows the manipulator unit 300 to operate as a stigmator to correct astigmatism. The size and polarity of the four-pole effect is determined by the potential difference between the respective apertures 304, 306. The orientation of the four-pole effect is determined by the orientation of the elongate slit. A high degree of control over a stigmation effect applied to an individual beam is thereby provided with minimal independent electrical connections being needed to the region where the stigmation effect is applied. The effect is depicted qualitatively in Figures 16 and 17 for the case where the openings in the second aperture body 302 are circular.

Figure 16 is a side sectional view along the *X* direction (i.e. parallel to the width of the elongate slits). In the upper part of the broken line region in Figure 16, a potential difference between the first aperture body 301 and the second aperture body 302 (in the *Z* direction) causes a relatively strong positive lensing effect in the vicinity of the aperture 304 in the first aperture body 301 in the *X* direction (parallel to the width 341 of the elongate slit). The relatively strong positive lensing effect arises because of the elongate shape. The focal length of an infinitely elongate lens (sometimes referred to as a slit lens) is given by 2 ∗ *U_{beam}*/*E_{local}.* A negative lens effect in the *X* direction arises in the vicinity of the corresponding aperture 306 in the second aperture body 302. The negative lens effect is smaller, however, because the aperture 306 is less elongate (or not elongate). The focal length of a perfectly circular negative lens (sometimes referred to as an aperture lens) is -4 ∗ *U_{beam}*/*E_{local}.* The net result is a residual positive lensing effect in the *X* direction. The residual positive lensing effect may be quantified by reference to the corresponding focal length, which would be approximately equal to 4 ∗ *U_{beam}*/*E_{local}* if the elongate slits are sufficiently elongate. Here *U_{beam}* is the local energy of the charged particle beam and *E_{local}* is the local electric field strength.

Figure 17 is a side sectional view along the *Y* direction (i.e. parallel to the length of the elongate slits). In this orientation, a much smaller (or negligible) positive lensing effect is present in the vicinity of each aperture 304 in the first aperture body 301 in the *Y* direction (parallel to the length 342 of the elongate slit). The negative lens effect in the *Y* direction arises in the vicinity of the aperture 306 in the second aperture body 302. The strength of this negative lens effect in the *Y* direction is the same as, or similar to, the strength of the negative lens effect at aperture 306 in the *X* direction, as shown in Figure 16. The negative lens effect in the *Y* direction is larger than the positive lens effect in the *Y* direction from the corresponding aperture 304 in the first aperture body 301. The net result is a residual negative lensing effect in the *Y* direction, with a corresponding focal length approximately equal to -4 ∗ *U_{beam}*/*E_{local}.*

In the alternative case where each opening in the second aperture body 302 is elongate and perpendicular to the corresponding elongate slit in the first aperture body 301, the contribution to the lensing effect by each opening in the second aperture body 302 is twice as strong in the direction perpendicular to the elongation of the opening and negligible in the direction parallel to the elongation of the opening. The net result is an astigmatism effect that is twice as strong. A residual positive lens effect is provided in the *X* direction that has a corresponding focal length approximately equal to 2 ∗ *U_{beam}*/*E_{local}.* A residual negative lens effect is provided in the *Y* direction that has a corresponding focal length approximately equal to -2 ∗ *U_{beam}*/*E_{local}.*

Thus, a residual positive lens effect is provided in the *X* direction and a residual negative lens effect is provided in the *Y* direction, which constitutes the four-pole effect mentioned above.

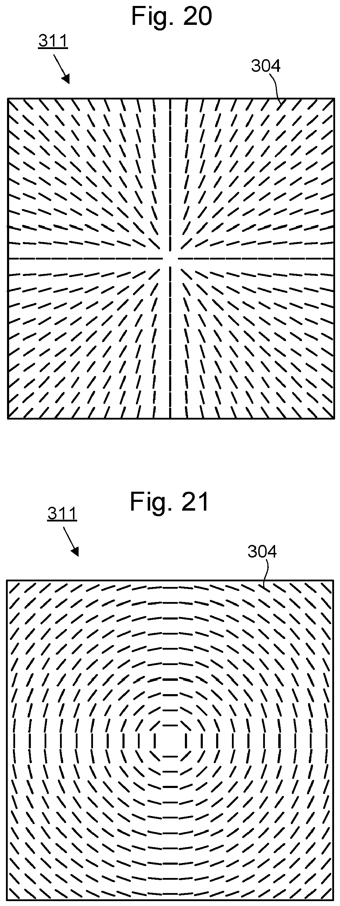

The potential difference between the apertures 304 and 306 may be provided using any of the first electrode systems 311 and second electrode systems 312 described above with reference to Figures 5-14. This includes use of electrode systems that are not necessarily restricted to providing potentials to groups of electrodes. Embodiments using the elongate slits may use electrode systems that allow potential differences to be controlled individually per elongate slit or corresponding opening facing the elongate slit. For example, in one arrangement, the first aperture body 301 comprises a first electrode system 311 for applying an electrical potential to an aperture perimeter surface of each aperture 304 of the first aperture body 304. The first electrode system 311 comprises a plurality of electrodes. Each electrode is electrically isolated from each other electrode of the first electrode system 311 and electrically connected to the aperture perimeter surface of a different respective one of the apertures 304 of the first aperture body 301. Alternatively or additionally, the second aperture body 302 may comprise a second electrode system 312 for applying an electrical potential to an aperture perimeter surface of each aperture 306 of the second aperture body 302. The second electrode system 312 may comprise a plurality of electrodes. Each electrode may be electrically isolated from each other electrode of the second electrode system 312 and electrically connected to the aperture perimeter surface of a different respective one of the apertures 306 of the second aperture body 302. Thus, either or both of the first aperture body 301 and the second aperture body 302 may comprise an electrode system of the type depicted in Figure 14. Typically, however, only one of the two aperture bodies 301 and 302 would comprise an electrode system of the type depicted in Figure 14 to avoid unnecessarily complex electrical routing requirements. For example, an electrode system of the type depicted in Figure 14 may be provided in the one of the two aperture bodies 301 and 302 that does not comprise the elongate slits. This arrangement may be favorable because the aperture body that does not comprise the elongate slits may have openings that are less elongate. Less elongate openings may provide more room for routing of electrical connections. As mentioned above, however, any other combination of the disclosed first electrode systems 311 and second electrode systems 312 may be used. The combination of a second electrode system 312 implemented as depicted in Figure 12 with the first aperture system 311 implemented as depicted in Figure 20 or 21 may be particularly efficient for example.

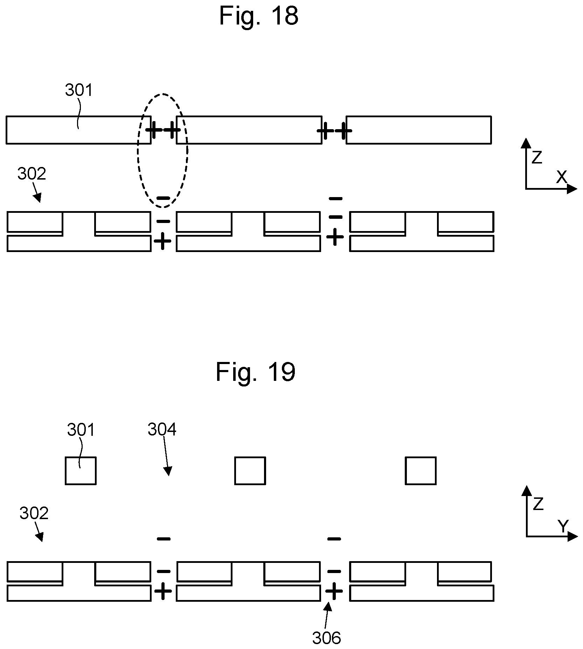

Alternatively or additionally to the example implementations for the first electrode system 311 and second electrode system 312 described above, the potential difference between the apertures 304 and 306 may be provided using local integrated electronics. The local integrated electronics may be implemented using CMOS technology for example. An example of an approach using CMOS technology is depicted in Figures 18 and 19. In this example, the second aperture body 302 comprises local integrated electronics for each aperture 306 of the second aperture body 302. The local integrated electronics is configured to apply an electrical potential to the aperture perimeter surface of the aperture 306. Alternatively or additionally, the first aperture body 301 may comprise local integrated electronics for each aperture 304 of the first aperture body 301, with the local integrated electronics being configured to apply an electrical potential to the aperture perimeter surface of the aperture 304. Alternatively or additionally, the potential difference between the apertures 304 and 306 may be provided using an integrated passive circuit. The integrated passive circuit may comprise a resistor network. The resistor network allows different electrical potentials to be applied to the aperture perimeter surfaces of at least a subset of the apertures of the first aperture body by potential division. The resistor network may comprise resistors in series. The resistors in series may be selected to achieve a desired series of steps in potential at nodes between the resistors (as is done in a potential divider). The potentials at the nodes are used to provide the desired range of potential differences between the apertures 304 and 306. The resistor network may be integrated into either or both of the first aperture body 301 and the second aperture body 302. The use of local integrated electronics and/or an integrated passive circuit to provide the required potential differences provides a high level of control and reduces routing difficulties. However, the construction of the respective first or second aperture body is made more complex. Additionally, the range of potential differences that can be applied by such integrated electronics and/or integrated passive circuit may be narrower than the range of potential differences that can be applied using electrodes driven externally (e.g. using electrode systems such as those described herein).

The orientation of the four-pole effect is determined by the orientation of the elongate slits. The orientations of the elongate slits can therefore be varied according to an expected symmetry of aberrations that are to be corrected.

In an embodiment, as exemplified in Figure 20, at least a majority of the elongate slits (labelled as apertures 304) are aligned radially relative to a common axis passing perpendicularly through a plane of the first aperture body 311. (The common axis may be vertical relative to the plane of the page in the orientation of Figure 20).

In an embodiment, as exemplified in Figure 21, at least a majority of the elongate slits (labelled as apertures 304) are aligned substantially azimuthally relative to the common axis, i.e. substantially perpendicularly to a radial direction relative to the common axis.

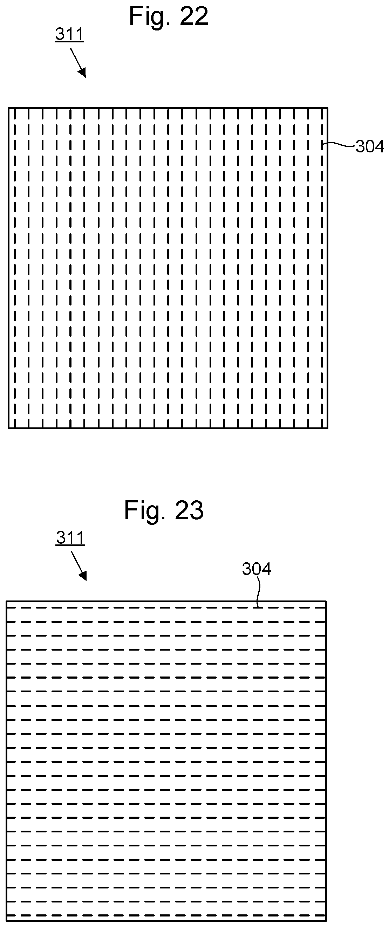

In an embodiment, as exemplified in Figure 22 and 23, at least a majority of the elongate slits are parallel to each other. The elongate slits may additionally be aligned within rows across the first aperture body, preferably extending between edges of the first aperture body 301. The rows may be linear. The rows may be mutually parallel. The rows may or may not be parallel with edges of the first aperture body 301.

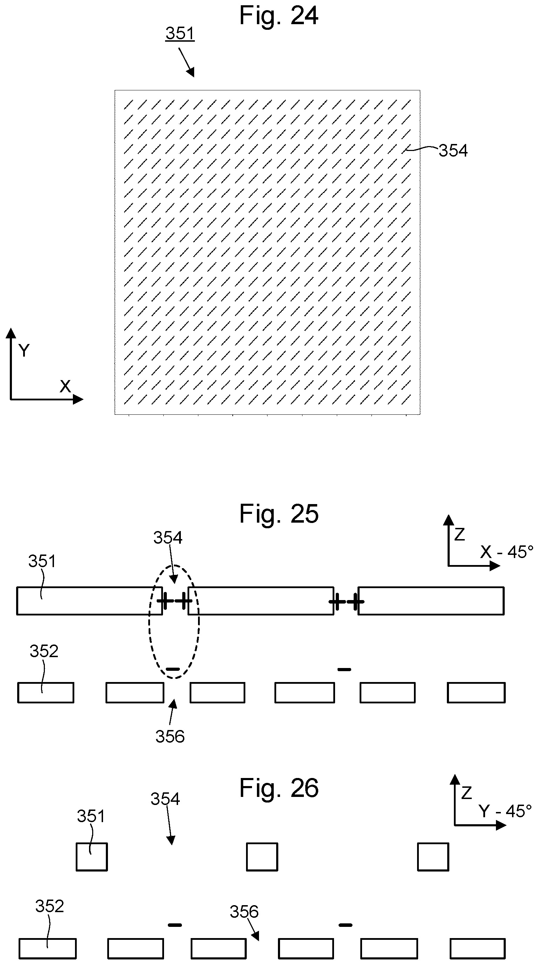

To provide fuller control of astigmatism, including control of magnitude and direction of the stigmation, an independently controllable and obliquely aligned further four-pole effect may be provided by further aperture bodies. An example of such an arrangement is depicted in Figures 24-26, with the elongate slits rotated by 45 degrees relative to the arrangement of Figures 15-17. In embodiments of this type, a third aperture body 351 and a fourth aperture body 352 are provided. The third aperture body 351 may be configured in any of the ways described above for the first aperture body 301. The fourth aperture body 352 may be configured in any of the ways described above for the second aperture body 302. Potential differences between the third aperture body 351 and the fourth aperture body 352 may be controlled in any of the ways described above for the first aperture body 301 and the second aperture body 302 in order to control the further four-pole effect. A plurality of apertures 354 in the third aperture body 351 are aligned with a corresponding plurality of apertures 304, 306, 356 in the first aperture body 301, second aperture body 302 and fourth aperture body 352. The alignment allows each of a respective plurality of charged particle beams to pass through the aperture assembly by passing through respective apertures 304, 306, 354, 356 in the four respective bodies, e.g. in the first aperture body 301, second aperture body 302, third aperture body 351 and fourth aperture body 352. Each of at least a subset of the apertures 354 in the third aperture body 351 consists of an elongate slit. Each corresponding aperture 356 in the fourth aperture body 352 consists of an opening that is smaller than the elongate slit in at least a direction parallel to a longest axis of the elongate slit. The elongate slits in the third aperture body 351 may be configured in any of the ways described above for the elongate slits in the first aperture body 301. The openings in the fourth aperture body 352 may be configured in any of the ways described above for the openings of the second aperture body 302. The elongate slits in the first aperture body 301 and third aperture body 351 are aligned such that each charged particle beam passes through elongate slits in the first aperture body 301 and the third aperture body 351 that are aligned obliquely relative to each other when viewed along a path of the charged particle beam. In the particular example shown, the elongate slits are aligned at 45 degrees, but other oblique angles may be chosen. By controlling the four-pole effect provided by the first and second aperture bodies 301, 302 and the obliquely aligned four-pole effect provided by the third and fourth aperture bodies 351, 352 it is possible to control both the magnitude and direction of an overall four-pole effect applied to each sub-beam of charged particles. A high degree of control is thereby provided without requiring an excessive number of independent electrical connections.

In an embodiment, the charged particle beam tool 40 comprises an electron detection device 240 that detects either or both of secondary electrons and backscattered electrons from the sample. In the examples shown in Figures 3 and 4, the electron detection device 240 is integrated with the objective lenses 118. The electron detection device 240 may, for example, comprise a CMOS chip detector integrated with a bottom electrode of one or more of the objective lenses 118. Alternatively, a secondary optical column may be provided to direct secondary electrons and/or backscattered electrons to an electron detection device 240 positioned elsewhere. As described above, the electron detection device 240 may generate signals that are sent to a controller 50 or a signal processing system as described above with reference to Figures 1 and 2, e.g. to construct images of areas of the sample 208 scanned over by the charged particle beam tool 40 or perform other post-processing.

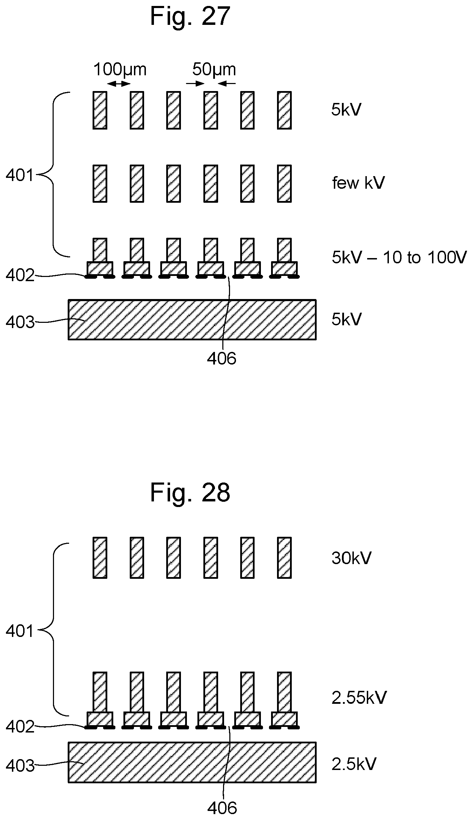

In an embodiment, as exemplified in Figures 27-31 discussed below, the objective lenses comprise multi-electrode lenses in which a bottom electrode of the multi-electrode lenses is integrated with a CMOS chip detector array. The multi-electrode lens may comprise three electrodes, as exemplified in Figure 27, two electrodes, as exemplified in Figure 28, or a different number of electrodes. Integration of a detector array into the objective lenses replaces the need for a secondary column for detecting the secondary electrons and backscattered electrons. The CMOS chip is preferably orientated to face a sample (because of the small distance (e.g. 100µm) between wafer and bottom of the electron-optical system). In an embodiment, electrodes to capture the secondary electron signals are formed in the top metal layer of the CMOS device. The electrodes can be formed in other layers. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In order to maximize the detection efficiency it is desirable to make the electrode surface as large as possible, so that substantially all the area of the array objective lens (excepting the apertures) is occupied by electrodes and each electrode has a diameter substantially equal to the array pitch. In an embodiment the outer shape of the electrode is a circle, but this can be made a square to maximize the detection area. Also the diameter of the through-substrate hole can be minimized. Typical size of the electron beam is in the order of 5 to 15 micron.

In an embodiment, a single electrode surrounds each aperture. In another embodiment, a plurality of electrode elements are provided around each aperture. The electrons captured by the electrode elements surrounding one aperture may be combined into a single signal or used to generate independent signals. The electrode elements may be divided radially (i.e. to form a plurality of concentric annuluses), angularly (i.e. to form a plurality of sector-like pieces), both radially and angularly or in any other convenient manner.

However a larger electrode surface leads to a larger parasitic capacitance, so a lower bandwidth. For this reason it may be desirable to limit the outer diameter of the electrode. Especially in case a larger electrode gives only a slightly larger detection efficiency, but a significantly larger capacitance. A circular (annular) electrode may provide a good compromise between collection efficiency and parasitic capacitance.

A larger outer diameter of the electrode may also lead to a larger crosstalk (sensitivity to the signal of a neighboring hole). This can also be a reason to make the electrode outer diameter smaller. Especially in case a larger electrode gives only a slightly larger detection efficiency, but a significantly larger crosstalk.

The back-scattered and/or secondary electron current collected by electrode is amplified by a Trans Impedance Amplifier.

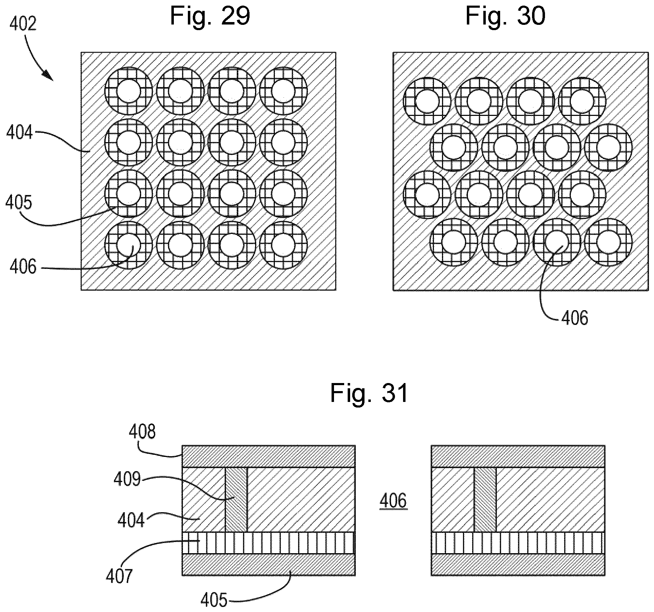

Exemplary embodiments are shown in Figures 27 and 28 which illustrate a multibeam objective lens 401 in schematic cross section. On the output side of the objective lens 401, the side facing the sample 403, a detector module 402 is provided. Figure 29 is a bottom view of detector module 402 which comprises a substrate 404 on which are provided a plurality of capture electrodes 405 each surrounding a beam aperture 406. The beam apertures 406 may be formed by etching through substrate 404. In the arrangement shown in Figure 29, the beam apertures 406 are shown in a rectangular array. The beam apertures 406 can also be differently arranged, e.g. in a hexagonal close packed array as depicted in Figure 30.

Figure 31 depicts at a larger scale a part of the detector module 402 in cross section. Capture electrodes 405 form the bottommost, i.e. most close to the sample, surface of the detector module 402. Between the capture electrodes 405 and the main body of the silicon substrate 404 a logic layer 407 is provided. Logic layer 407 may include amplifiers, e.g. Trans Impedance Amplifiers, analogue to digital converters, and readout logic. In an embodiment, there is one amplifier and one analogue to digital converter per capture electrode 405. Logic layer 407 and capture electrodes 405 can be manufactured using a CMOS process with the capture electrodes 405 forming the final metallization layer.

A wiring layer 408 is provided on the backside of substrate 404 and connected to the logic layer 407 by through-silicon vias 409. The number of through-silicon vias 409 need not be the same as the number of beam apertures 406. In particular if the electrode signals are digitized in the logic layer 407 only a small number of through-silicon vias may be required to provide a data bus. Wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector module 402.

In embodiments where the aperture assembly 370 is integrated with a plurality of objective lenses, the aperture assembly 370 could be integrated with the multibeam objective lens 401 of Figure 27 or Figure 28. In such a case, the first aperture body 301 would comprise one of the electrodes of the multibeam objective lens of Figure 27 or Figure 28 and the second aperture body 302 would comprise a different one of the electrodes of the multibeam objective lens 401.

Embodiments of the disclosure may be provided in the form of methods, which may use any of the arrangements described above, or other arrangements.

In one class of embodiment a method of manipulating charged particles, optionally an inspection method, is provided that comprises directing a plurality of charged particle beams through an aperture assembly 370 onto a sample 208. The charged particle beams are electrostatically manipulated by applying electrical potentials to electrodes in the aperture assembly. The aperture assembly 370 may take any of the forms described above. The aperture assembly 370 may thus comprise a first aperture body 301 and a second aperture body 302. A plurality of apertures 304 in the first aperture body 301 are aligned with a corresponding plurality of apertures 306 in the second aperture body 302 so that each of the charged particle beams pass through the aperture assembly 370 by passing through respective apertures 304, 306 in the first aperture body 301 and the second aperture body 302. The applying of electrical potentials comprises applying electrical potentials to a plurality of electrodes that are each electrically isolated from each other and electrically connected simultaneously to the aperture perimeter surfaces of a different one of a plurality of groups of the apertures of the first aperture body 301.

In another class of embodiment, a method of manipulating charged particles, optionally an inspection method, is provided that comprises directing a plurality of charged particle beams through an aperture assembly onto a sample 208. The charged particle beams are electrostatically manipulated by applying electrical potentials to electrodes in the aperture assembly. The aperture assembly may take any of the forms described above. The aperture assembly may thus comprise a first aperture body 301 and a second aperture body 302. A plurality of apertures 304 in the first aperture body 301 are aligned with a corresponding plurality of apertures 306 in the second aperture body 302 so that each of the charged particle beams pass through the aperture assembly by passing through respective apertures 304, 306 in the first aperture body 301 and the second aperture body 302. The applying of electrical potentials comprises applying electrical potential differences between apertures 304 in the first aperture body 301 and corresponding apertures 306 in the second aperture body 302. Each of at least a subset of the apertures 304 in the first aperture body 301 consists of an elongate slit. Each corresponding aperture 306 in the second aperture body 302 consists of an opening that is smaller than the elongate slit in at least a direction parallel to a longest axis of the elongate slit. The electrical potentials may be applied in such a way as to reduce astigmatism in the charged particle beams.

The embodiments may further be described using the following clauses:
1. An aperture assembly for a beam manipulator unit of a charged particle projection apparatus, the aperture assembly comprising:
   a first aperture body and a second aperture body, wherein:
   a plurality of apertures in the first aperture body are aligned with a corresponding plurality of apertures in the second aperture body, the alignment being such as to allow a path of each of a respective plurality of charged particle beams to pass through the aperture assembly by passing through respective apertures in the first aperture body and the second aperture body;
   the first aperture body comprises a first electrode system for applying an electrical potential to an aperture perimeter surface of each aperture in the first aperture body;
      the second aperture body comprises a second electrode system for applying an electrical potential to an aperture perimeter surface of each aperture in the second aperture body; and
      the first electrode system comprises a plurality of electrodes, each electrode being electrically isolated from each other electrode and electrically connected simultaneously to the aperture perimeter surfaces of a different one of a plurality of groups of the apertures in the first aperture body.
2. The assembly of clause 1, wherein at least two of the groups of apertures contain the same number of apertures.
3. The assembly of clause 1 or 2, wherein each electrode of the first electrode system comprises an elongate conductive strip.
4. The assembly of clause 3, wherein the apertures in the first aperture body are arranged in an array, preferably a regular array.
5. The assembly of clause 4, wherein the conductive strips are parallel to each other and perpendicular to a principle axis of the array.
6. The assembly of clause 5, wherein a pitch of the conductive strips parallel to a short axis of the conductive strips is larger than a pitch of the array parallel to the short axis.
7. The assembly of clause 5, wherein a pitch of the conductive strips parallel to a short axis of the conductive strips is equal to a pitch of the array parallel to the short axis.
8. The assembly of any preceding clause, wherein the plurality of electrodes comprises a plurality of conductive elements configured to tessellate with each other.
9. The assembly of clause 1 or 2, wherein the plurality of electrodes comprises a plurality of conductive elements comprising at least portions of concentric loops.
10. The assembly of any preceding clause, wherein the second electrode system comprises an electrode electrically connected to all of the aperture perimeter surfaces of the second aperture body.
11. The assembly of any of clauses 1 to 9, wherein the second electrode system comprises a plurality of electrodes, each electrode being electrically isolated from each other electrode and electrically connected simultaneously to the aperture perimeter surfaces of a different one of a plurality of groups of the apertures of the second electrode system.
12. The assembly of clause 11, wherein:
   each electrode of the first electrode system comprises an elongate conductive strip;
   each electrode of the second electrode system comprises an elongate conductive strip; and
   the conductive strips of the first electrode system are non-parallel with the conductive strips of the second electrode system.
13. The assembly of clause 12, wherein the conductive strips of the first electrode system are parallel to each other, the conductive strips of the second electrode system are parallel to each other, and the conductive strips of the first electrode system are perpendicular to the conductive strips of the second electrode system.
14. The assembly of any preceding clause, wherein the apertures in the first aperture body and/or the apertures in the second aperture body are circular or oval.
15. The assembly of any preceding clause, wherein:
   each of at least a subset of the apertures in the first aperture body consists of an elongate slit; and
   each corresponding aperture in the second aperture body consists of an opening that is smaller than the elongate slit in at least a direction parallel to a longest axis of the elongate slit.
16. An aperture assembly for a beam manipulator unit of a charged particle projection apparatus, comprising:
   a first aperture body and a second aperture body, wherein:
      a plurality of apertures in the first aperture body are aligned with a corresponding plurality of apertures in the second aperture body, the alignment being such as to allow a path of each of a respective plurality of charged particle beams to pass through the aperture assembly by passing through respective apertures in the first aperture body and second aperture body;
      each of at least a subset of the apertures in the first aperture body consists of an elongate slit; and
   each corresponding aperture in the second aperture body consists of an opening that is smaller than the elongate slit in at least a direction parallel to a longest axis of the elongate slit.
17. The assembly of clause 16, wherein:
   the first aperture body comprises a first electrode system for applying an electrical potential to an aperture perimeter surface of each aperture of the first aperture body, the first electrode system comprising a plurality of electrodes, each electrode being electrically isolated from each other electrode of the first electrode system and electrically connected to the aperture perimeter surface of a different respective one of the apertures of the first aperture body; and/or
   the second aperture body comprises a second electrode system for applying an electrical potential to an aperture perimeter surface of each aperture of the second aperture body, the second electrode system comprising a plurality of electrodes, each electrode being electrically isolated from each other electrode of the second electrode system and electrically connected to the aperture perimeter surface of a different respective one of the apertures of the second aperture body.
18. The assembly of clause 16, wherein:
   the first aperture body comprises local integrated electronics for each aperture of the first aperture body, the local integrated electronics being configured to apply an electrical potential to the aperture perimeter surface of the aperture; and/or
   the second aperture body comprises local integrated electronics for each aperture of the second aperture body, the local integrated electronics being configured to apply an electrical potential to the aperture perimeter surface of the aperture.
19. The assembly of clause 16 or 18, wherein:
   the first aperture body comprises an integrated passive circuit comprising a resistor network, the resistor network being configured to allow different electrical potentials to be applied to the aperture perimeter surfaces of at least a subset of the apertures of the first aperture body by potential division; and/or
   the second aperture body comprises an integrated passive circuit comprising a resistor network, the resistor network being configured to allow different electrical potentials to be applied to the aperture perimeter surfaces of at least a subset of the apertures of the second aperture body by potential division.
20. The assembly of any of clauses 15 to 19, wherein each of at least a subset of the elongate slits is a substantially linear slit.
21. The assembly of any of clauses 15 to 20, wherein each of at least a subset of the openings has substantially one of the following shapes: circle, oval, ellipse.
22. The assembly of any of clauses 15 to 21, wherein at least a majority of the elongate slits are aligned radially relative to a common axis passing perpendicularly through a plane of the first aperture body.
23. The assembly of any of clauses 15 to 22, wherein at least a majority of the elongate slits are aligned perpendicularly to a radial direction relative to a common axis passing perpendicularly through a plane of the first aperture body.
24. The assembly of any of clauses 15 to 23, wherein at least a majority of the elongate slits are parallel to each other.
25. The assembly of any of clauses 15 to 24, wherein a largest in-plane dimension of each opening in the first aperture body is substantially equal to a smallest in-plane dimension of the corresponding elongate slit in the second aperture body.
26. The assembly of any of clauses 15 to 25, wherein:
   the aperture assembly further comprises a third aperture body and a fourth aperture body; a plurality of apertures in the third aperture body are aligned with a corresponding plurality of apertures in the first aperture body, second aperture body and fourth aperture body, the alignment being such as to allow a path of each of a respective plurality of charged particle beams to pass through the aperture assembly by passing through respective apertures in the first aperture body, second aperture body, third aperture body and fourth aperture body;
   each of at least a subset of the apertures in the third aperture body consists of an elongate slit; each corresponding aperture in the fourth aperture body consists of an opening that is smaller than the elongate slit in at least a direction parallel to a longest axis of the elongate slit; and
      the elongate slits in the first aperture body and third aperture body are aligned such that each charged particle beam passes through elongate slits in the first aperture body and the third aperture body that are aligned obliquely relative to each other when viewed along the path of the charged particle beam.
27. A beam manipulator unit for a charged particle projection apparatus, comprising:
   the aperture assembly of any preceding clause; and
   an electrical driving unit configured to apply electrical potentials to the aperture perimeter surfaces of apertures in the first aperture body and second aperture body while a plurality of charged particle beams are directed through the aperture assembly towards a sample.
28. A charged particle projection apparatus, comprising:
   the beam manipulator unit of clause 27; and
   a plurality of lenses, each lens configured to project a respective sub-beam of charged particles.
29. The apparatus of clause 28, wherein the aperture assembly is integrated with, or directly adjacent to, the plurality of lenses.
30. The apparatus of clause 29, wherein:
   each lens comprises a multi-electrode lens;
   the first aperture body comprises a first electrode of the multi-electrode lens; and
   the first aperture body comprises a first electrode system comprising a plurality of electrodes that are electrically isolated from the first electrode of the multi-electrode lens.
31. The apparatus of clause 30, wherein:
   the second aperture body comprises a second electrode of the multi-electrode lens; and
   the second aperture body comprises a second electrode system comprising a plurality of electrodes that are electrically isolated from the second electrode of the multi-electrode lens.
32. The apparatus of clause 30 or 31, wherein the electrical driving unit is configured to control potentials of the electrodes of the first electrode system such that a potential difference between the highest potential electrode and the lowest potential electrode of the first electrode system is smaller than a difference between an average potential of the electrodes of the first electrode system and an average potential of the electrodes of the second electrode system.
33. The apparatus of any of clauses 28 to 32, wherein the plurality of lenses comprises a plurality of objective lenses configured to project respective sub-beams onto a sample.
34. The apparatus of any of clauses 28 to 32, wherein the plurality of lenses comprises a plurality of condenser lenses configured to focus respective sub-beams to intermediate foci upbeam from a plurality of objective lenses configured to project the sub-beams onto a sample.
35. The apparatus of any of clauses 28 to 32, wherein:
   the apparatus comprises a plurality of condenser lenses configured to focus respective sub-beams to intermediate foci in an intermediate image plane; and
   the aperture assembly is provided in, or directly adjacent to, the intermediate image plane.
36. A charged particle beam tool, comprising:
   the charged particle projection apparatus of any of clauses 28 to 35; and
   an electron detection device configured to detect either or both of secondary electrons and backscattered electrons from the sample.
37. A method of manipulating charged particle beams, comprising:
   directing a plurality of charged particle beams through an aperture assembly onto a sample; and
   electrostatically manipulating the charged particle beams by applying electrical potentials to electrodes in the aperture assembly, wherein:
   the aperture assembly comprises a first aperture body and a second aperture body;
   a plurality of apertures in the first aperture body are aligned with a corresponding plurality of apertures in the second aperture body so that each of the charged particle beams pass through the aperture assembly by passing through respective apertures in the first aperture body and the second aperture body; and
   the applying of electrical potentials comprises applying electrical potentials to a plurality of electrodes that are each electrically isolated from each other and electrically connected simultaneously to the aperture perimeter surfaces of a different one of a plurality of groups of the apertures of the first aperture body.
38. A method of manipulating charged particle beams, comprising:
   directing a plurality of charged particle beams through an aperture assembly onto a sample; and
   electrostatically manipulating the charged particle beams by applying electrical potentials to electrodes in the aperture assembly, wherein:
   the aperture assembly comprises a first aperture body and a second aperture body;
   a plurality of apertures in the first aperture body are aligned with a corresponding plurality of apertures in the second aperture body so that each of the charged particle beams pass through the aperture assembly by passing through respective apertures in the first aperture body and the second aperture body;
   the applying of electrical potentials comprises applying electrical potential differences between apertures in the first aperture body and corresponding apertures in the second aperture body; each of at least a subset of the apertures in the first aperture body consists of an elongate slit; and each corresponding aperture in the second aperture body consists of an opening that is smaller than the elongate slit in at least a direction parallel to a longest axis of the elongate slit.
39. The method of clause 38, wherein the electrical potentials are applied in such a way as to reduce astigmatism in the charged particle beams.
40. An aperture assembly for a manipulator unit of a charged particle multi-beam projection apparatus, the aperture assembly comprising:
   a first aperture body in which are defined a first array of apertures; and
   a second aperture body in which are defined a corresponding array of apertures that is aligned with the first array of apertures to define paths for respective charged particle beams of the multi-beam through the aperture assembly;
   a first electrode system associated with the first aperture body configured to apply an electrical potential to a perimeter surface of each aperture of the first aperture body;
   a second electrode system associated with the second aperture body configured to apply an electrical potential to a perimeter surface of each aperture of the second aperture body,
      wherein the first electrode system comprises a plurality of electrodes, each electrode being electrically isolated from each other electrode and electrically connected simultaneously to the perimeter surface of a different one of a plurality of groups of the apertures of the first aperture body.
41. An aperture assembly for a beam manipulator unit of a charged particle multi-beam projection apparatus, comprising:
   a first aperture body in which is defined a first plurality of apertures; and
   a second aperture body in which is defined a corresponding plurality of apertures that are positioned with respect to the first plurality of apertures to define paths for respective charged particle beams of the multi-beam through the aperture assembly,
      wherein each of at least a subset of the apertures in the first aperture body is an elongate slit; and each corresponding aperture of corresponding plurality of apertures to the elongate slit is an opening having an aspect ratio smaller than the elongate slit.
42. A beam manipulator unit of a charged particle multi-beam projection apparatus, the manipulator unit comprising a lens comprising:
   an up-beam lens aperture array with an associated up-beam perturbing electrode array; and
   a down-beam lens aperture array with an associated down-beam perturbing electrode array, wherein the up-beam lens aperture array, the down-beam lens aperture array and the perturbing arrays are positioned with respect to each other so that the apertures in each array define paths for respective charged particle beams of the multi-beam through the manipulator unit; and
   the up-beam and down-beam perturbing electrodes are controllable to apply perturbing fields to the fields generated by the lens during operation.
43. A method of manipulating charged particle beams, comprising:
   providing a lens comprising an up-beam lens aperture array with an associated up-beam perturbing electrode array; and a down-beam lens aperture array with an associated down-beam perturbing electrode array;
   passing multiple charged particle beams through respective apertures in each of the up-beam lens aperture array and the down-beam lens aperture array; and
   controlling the up-beam and down-beam perturbing electrodes to apply perturbing fields to fields generated by the lens.

Any of the charged particle beam tools 40 discussed herein may be an assessment tool. An assessment tool according to an embodiment of the disclosure may be a tool which makes a qualitative assessment of a sample (e.g. pass/fail), one which makes a quantitative measurement (e.g. the size of a feature) of a sample or which generates an image of map of a sample. Examples of assessment tools are inspection tools (e.g. for identifying defects), review tools (e.g. for classifying defects) and metrology tools.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. An aperture assembly for a beam manipulator unit of a charged particle projection apparatus, comprising:
a first aperture body and a second aperture body, wherein:
a plurality of apertures in the first aperture body are aligned with a corresponding plurality of apertures in the second aperture body, the alignment being such as to allow a path of each of a respective plurality of charged particle beams to pass through the aperture assembly by passing through respective apertures in the first aperture body and second aperture body;
each of at least a subset of the apertures in the first aperture body consists of an elongate slit; and
each corresponding aperture in the second aperture body consists of an opening that is smaller than the elongate slit in at least a direction parallel to a longest axis of the elongate slit.

2. The assembly of claim 1, wherein:
the first aperture body comprises a first electrode system for applying an electrical potential to an aperture perimeter surface of each aperture of the first aperture body, the first electrode system comprising a plurality of electrodes, each electrode being electrically isolated from each other electrode of the first electrode system and electrically connected to the aperture perimeter surface of a different respective one of the apertures of the first aperture body; and/or
the second aperture body comprises a second electrode system for applying an electrical potential to an aperture perimeter surface of each aperture of the second aperture body, the second electrode system comprising a plurality of electrodes, each electrode being electrically isolated from each other electrode of the second electrode system and electrically connected to the aperture perimeter surface of a different respective one of the apertures of the second aperture body.

3. The assembly of claim 1, wherein:
the first aperture body comprises local integrated electronics for each aperture of the first aperture body, the local integrated electronics being configured to apply an electrical potential to the aperture perimeter surface of the aperture; and/or
the second aperture body comprises local integrated electronics for each aperture of the second aperture body, the local integrated electronics being configured to apply an electrical potential to the aperture perimeter surface of the aperture.

4. The assembly of claim 1 or 3, wherein:
the first aperture body comprises an integrated passive circuit comprising a resistor network, the resistor network being configured to allow different electrical potentials to be applied to the aperture perimeter surfaces of at least a subset of the apertures of the first aperture body by potential division; and/or
the second aperture body comprises an integrated passive circuit comprising a resistor network, the resistor network being configured to allow different electrical potentials to be applied to the aperture perimeter surfaces of at least a subset of the apertures of the second aperture body by potential division.

5. The assembly of any of claims 1 to 4, wherein each of at least a subset of the elongate slits is a substantially linear slit.

6. The assembly of any of claims 1 to 5, wherein each of at least a subset of the openings has substantially one of the following shapes: circle, oval, ellipse.

7. The assembly of any of claims 1 to 6, wherein at least a majority of the elongate slits are aligned radially relative to a common axis passing perpendicularly through a plane of the first aperture body.

8. The assembly of any of claims 1 to 7, wherein at least a majority of the elongate slits are aligned perpendicularly to a radial direction relative to a common axis passing perpendicularly through a plane of the first aperture body.

9. The assembly of any of claims 1 to 8, wherein at least a majority of the elongate slits are parallel to each other.

10. The assembly of any of claims 1 to 9, wherein a largest in-plane dimension of each opening in the first aperture body is substantially equal to a smallest in-plane dimension of the corresponding elongate slit in the second aperture body.

11. The assembly of any of claims 1 to 10, wherein:
the aperture assembly further comprises a third aperture body and a fourth aperture body;
a plurality of apertures in the third aperture body are aligned with a corresponding plurality of apertures in the first aperture body, second aperture body and fourth aperture body, the alignment being such as to allow a path of each of a respective plurality of charged particle beams to pass through the aperture assembly by passing through respective apertures in the first aperture body, second aperture body, third aperture body and fourth aperture body;
each of at least a subset of the apertures in the third aperture body consists of an elongate slit;
each corresponding aperture in the fourth aperture body consists of an opening that is smaller than the elongate slit in at least a direction parallel to a longest axis of the elongate slit; and
the elongate slits in the first aperture body and third aperture body are aligned such that each charged particle beam passes through elongate slits in the first aperture body and the third aperture body that are aligned obliquely relative to each other when viewed along the path of the charged particle beam.

12. A beam manipulator unit for a charged particle projection apparatus, comprising:
the aperture assembly of any preceding claim; and
an electrical driving unit configured to apply electrical potentials to the aperture perimeter surfaces of apertures in the first aperture body and second aperture body while a plurality of charged particle beams are directed through the aperture assembly towards a sample.

13. A charged particle projection apparatus, comprising:
the beam manipulator unit of claim 12; and
a plurality of lenses, each lens configured to project a respective sub-beam of charged particles.

14. The apparatus of claim 13, wherein the aperture assembly is integrated with, or directly adjacent to, the plurality of lenses.

15. The apparatus of any of claims 13 to 14, wherein the plurality of lenses comprises a plurality of objective lenses configured to project respective sub-beams onto a sample, and/or wherein the plurality of lenses comprises a plurality of condenser lenses configured to focus respective sub-beams to intermediate foci upbeam from a plurality of objective lenses configured to project the sub-beams onto a sample.
